# EUROPÄISCHE PATENTANMELDUNG

(11) **EP 4 369 004 A1**
(43) Veröffentlichungstag der Anmeldung: **15.05.2024**
(21) Anmeldenummer: 23205673.9
(22) Anmeldetag: 25.10.2023
(51) Int. Cl.: G01R 15/18

(54) **ELEKTRISCHE SCHALTUNGSANORDNUNG UND VERFAHREN ZUR GALVANISCH GETRENNTEN, ALLSTROMSENSITIVEN DIFFERENZSTROM-MESSUNG**

(30) Priorität: 08.11.2022 DE 102022129457
(71) Anmelder: Bender GmbH & Co. KG, 35305 Grünberg (DE)
(72) Erfinder: BECKER, Pascal, 35305 Grünberg (DE)
(74) Vertreter: advotec.

(57) **Zusammenfassung**

Die Erfindung betrifft eine elektrische Schaltungsanordnung (2) und ein Messverfahren zur galvanisch getrennten, allstromsensitiven Differenzstrommessung mit Erfassen eines Differenzstroms (I_{d}) mittels eines Messstromwandlers (4) mit einem Ringkern und genau einer Sekundärwicklung (6), Bestromen der Sekundärwicklung (6) und Erzeugen eines zeitmodulierten, binären Messsignals (V) mit einer jeweiligen Verweilzeit (Tₕ, Tₗ) in einem ersten Zustand (S₁) und einem zweiten Zustand (S₂) mittels einer Treiberschaltung (12) mit einer Oszillatorschaltung (22), Auswerten der Verweilzeiten (Tₕ, Tₗ) mittels einer Recheneinheit (32) und Ausgeben eines Differenzstrom-Messwertes (Iₘ, I'ₘ) mittels einer Datenschnittstelle (52), wobei die Treiberschaltung (12) mit der Oszillatorschaltung (22) eine integrale bauliche Einheit in Form eines Treiberbausteins (24) bildet, welcher von einer Spannungsversorgungseinrichtung (42) zusammen mit der Recheneinheit (32) mit einer gemeinsamen, unipolaren Betriebsspannung (Ub) versorgt wird.

## Beschreibung

Die Erfindung betrifft eine elektrische Schaltungsanordnung und ein Verfahren zur galvanisch getrennten, allstromsensitiven DifferenzstromMessung, bestehend aus einem Messstromwandler mit einem Ringkern und genau einer Sekundärwicklung zur Erfassung eines Differenzstroms, einer Treiberschaltung mit einer Oszillatorschaltung zur Bestromung der Sekundärwicklung und zur Erzeugung eines zeitmodulierten, binären Messsignals mit einer jeweiligen Verweilzeit in einem ersten Zustand und einem zweiten Zustand und aus einer Recheneinheit mit einer Datenschnittstelle zur Auswertung der Verweilzeiten und zur Ausgabe eines Differenzstrom-Messwertes.

Bekannt sind Messvorrichtungen und Messverfahren zur Überwachung elektrischer Anlagen, die auf dem Differenzstrom-Messprinzip beruhen. Derartige Messvorrichtungen basieren auf der Tatsache, dass im fehlerfreien Betrieb einer elektrischen Anlage die vektorielle Summe der Ströme (Primärstrom) auf allen aktiven Leitern einer Zuleitung, insbesondere auf der Leitung eines Stromversorgungssystems, gleich Null ist und somit kein Magnetfeld in einem die Zuleitung umschließenden, magnetisierbaren Ringkern eines Messstromwandlers existiert. Entsteht aber beispielsweise aufgrund eines Isolationsfehlers ein Fehlerstrom, der außerhalb der Zuleitung abfließt, ergibt sich primärseitig ein Differenzstrom. Ein durch diesen Differenzstrom innerhalb des Ringkerns hervorgerufener, veränderlicher Magnetfluss induziert in einer Sekundärwicklung des Messstromwandlers eine Spannung, deren Größe eine Aussage über die Höhe des Differenzstroms erlaubt.

Ist der Differenzstrom sehr klein, wie im Fall der vorausschauenden Erkennung eines durch einen sich stetig verschlechternden Isolationszustand des Stromversorgungssystems hervorgerufenen Fehlerstroms, wird eine Messvorrichtung mit hoher Sensitivität benötigt. Auch für weitere Anwendungsgebiete aus dem Bereich der Fehlerstromüberwachung, beispielsweise zur Erfassung eines Prüfstromimpulses in ungeerdeten Stromversorgungssystemen, kann es daher erforderlich sein, auch sehr geringe Differenzströme in dem Bereich bis maximal 300mA mit hoher Auflösung erfassen zu können.

Bekannte Verfahren zur allstromsensitiven Differenzstrommessung mittels eines Messstromwandlers, wie beispielsweise in der Patentschrift EP 2 813 856 B1 offenbart, nutzen Oszillatorschaltungen, mit der die Magnetisierungskurve des Wandlerkerns des Messstromwandlers durch einen gesteuerten sekundärseitigen Stromfluss zwischen einer oberen und einer unteren Sättigung oszillierend durchfahren wird. Aus dem zeitlichen Verlauf dieser Oszillation lassen sich zwei Zustände definieren und durch die Bestimmung der Verweilzeiten in dem jeweiligen Zustand lässt sich eine Messgröße bilden, aus der sich der primärseitige Differenzstrom durch den Messstromwandler ermitteln lässt. Allerdings kommt in der genannten Patentschrift eine anwendungsspezifische integrierte Schaltung (ASIC) zum Einsatz, welche einen hohen Entwicklungsaufwand und hohe Initialkosten erforderlich macht.

Auch ist aus der Offenlegungsschrift EP 3 893 006 A1 eine elektrische Schaltungsanordnung und ein Verfahren zur galvanisch getrennten, allstromsensitiven Differenzstrommessung bekannt, welches auf einer Treiberschaltung zur Bestromung eines Ringkern-Stromwandlers und einer ersten Oszillatorschaltung zur Steuerung der Treiberschaltung beruht. Die Auswertung des Oszillatorsignals erfolgt hochauflösend mittels eines Taktsignals, das in einer baulich getrennten, zweiten Oszillatorschaltung erzeugt wird und somit weiteren Hardware-Aufwand erfordert.

Weiter zeigt die Patentschrift CN104655919B einen quasi-digitalen DC-Stromsensor zur Hochstrommessung basierend auf einer Multivibratorschaltung, die einen Operationsverstärker als Komparator zur Erzeugung eines bipolaren Erregerstroms für die Speisung eines nichtlinearen Messtransformators aufweist. Die alternierende Erregerspannung wird in ein positives pulsförmiges Signal umgewandelt, dessen Tastverhältnis mikroprozessorbasiert ausgewertet wird. Allerdings ist der Stromsensor zur Messung geringer, allstromsensitiver Differenzströme mit hoher Auflösung wegen seiner Ausrichtung auf eine hochstromige DC-Absolutstrommessung nicht geeignet.

Zudem verlangt der diskrete schaltungstechnische Aufbau der Multivibratorschaltung - neben der Spannungsversorgung des Mikroprozessors - eine weitere definierte Spannungsversorgung.

Der vorliegenden Erfindung liegt somit die Aufgabe zugrunde, eine elektrische Schaltungsanordnung und ein Messverfahren zur galvanisch getrennten, allstromsensitiven Differenzstrommessung zu schaffen, welche eine Messung eines vorzugsweise im Bereich bis zu 300mA liegenden Differenzstroms erlauben sowie eine flexible Auswertung der Messwerte bieten und zugleich schaltungstechnisch und wirtschaftlich effizient implementierbar sind.

Diese Aufgabe wird in Verbindung mit den Merkmalen des Oberbegriffs in Anspruch 1 dadurch gelöst, dass die Treiberschaltung mit der Oszillatorschaltung eine integrale bauliche Einheit in Form eines Treiberbausteins bildet, welcher ausgelegt ist, von einer Spannungsversorgungseinrichtung zusammen mit der Recheneinheit mit einer gemeinsamen, unipolaren Betriebsspannung versorgt zu werden.

Zur Erfassung des Differenzstroms weist die erfindungsgemäße elektrische Schaltungsanordnung einen Messstromwandler mit einem Ringkern (Ringkern-Stromwandler) auf, dessen Magnetisierungskurve einen ausgeprägten positiven und negativen Sättigungsbereich zeigt, zwischen denen ein näherungsweise linearer Bereich verläuft. Der Ringkern-Stromwandler weist genau eine Sekundärwicklung (Messwicklung) auf, die von einer Treiberschaltung mit einer Oszillatorschaltung bestromt wird und ein zeitmoduliertes, binäres Messsignals mit einer jeweiligen Verweilzeit in einem ersten Zustand und einem zweiten Zustand erzeugt.

Dabei wird die Treiberschaltung von der Oszillatorschaltung in der Weise angesteuert, dass die Magnetisierungskurve in Folge des Stromflusses durch die Sekundärwicklung in beiden Richtungen in dem linearen Bereich zwischen der positiven und der negativen Sättigung oszillierend durchfahren wird.

Die Unterscheidung zwischen dem linearen Bereich und dem jeweiligen Sättigungsbereich auf der Magnetisierungskurve erfolgt in der Oszillatorschaltung durch eine Betragsmessung des Sekundärstroms und dem Vergleich mit einem hinreichend hoch gewählten (Sekundärstrom-)Sättigungs-Grenzwert, welcher einem Stromwert im Sättigungsbereich des Kernmaterials entspricht.

Überschreitet der Sekundärstrom den Sättigungs-Grenzwert, kippt die Oszillatorschaltung und die Stromrichtung in der Sekundärwicklung wird umgekehrt.

Unter Auswertung der Nulldurchgänge des Sekundärstroms - also in dem allein durch den Differenzstrom bestimmten Arbeitsunkt auf der Magnetisierungskurve - und aus dessen Kipppunkten - also in den Sättigungsbereichen auf der Magnetisierungskurve - kann aus dem Sekundärstrom-Verlauf ein zeitmoduliertes, binäres Messsignal mit Verweilzeiten in einem ersten Zustand (High-Phase) und in einem zweiten Zustand (Low-Phase) abgeleitet werden.

Die Verweilzeiten in dem ersten Zustand und in dem zweiten Zustand sind dabei ausgehend von dem durch den Differenzstrom vorgegebenen Arbeitspunkt auf der Magnetisierungskennlinie bis zum Erreichen des jeweiligen Sättigungspunktes in Abhängigkeit der Lage des Arbeitspunktes unterschiedlich lange und führen damit zu dem zeitlich modulierten, binären Messsignal.

Das Durchfahren der Magnetisierungskurve wird also über eine möglichst lineare Funktion (linearer Bereich der Magnetisierungskurve) in die Verweilzeiten des zeitmodulierten, binären Messsignals abgebildet, wobei sich die den durchfahrenen Strecken auf der Magnetisierungskurve entsprechenden Verweilzeiten in Abhängigkeit des Arbeitspunktes ergeben.

Das zeitmodulierte, binäre Messsignal (Oszillatorsignal) weist daher je nach Lage des Arbeitspunktes und damit in Abhängigkeit des Differenzstroms unterschiedlich lange High-/Low-Phasen (erster Zustand/zweiter Zustand) auf.

Die Auswertung des Messsignals besteht in der Bestimmung der jeweiligen Verweilzeit in dem ersten/zweiten Zustand durch ein Taktsignal und erfolgt mittels einer Recheneinheit, welche vorzugsweise als Mikroprozessor ausgeführt ist.

Der Einsatz einer derartigen, programmierbaren Recheneinheit und damit die softwarebasierte Auswertung bieten in vorteilhafter Weise eine erhöhte Flexibilität hinsichtlich der Anpassung an unterschiedliche Messstromwandler-Varianten und ermöglichen eine einfache und schnelle Änderung der Messparameter - wie beispielsweise eine an den Messbereich angepasste Messauflösung.

Die Anzahl der innerhalb der jeweiligen Verweilzeiten mit dem Taktsignal gezählten Taktimpulse führt nach einer geeigneten Signalverarbeitung (Tiefpass-Filterung) zu einem dem Differenzstrom proportionalen Gleichanteil, der den Differenzstrom-Messwert ergibt.

Über die Datenschnittstelle wird dieser Differenzstrom-Messwert ausgegeben.

Erfindungsgemäß bildet die Treiberschaltung mit der Oszillatorschaltung eine integrale bauliche Einheit in Form eines Treiberbausteins. Der Treiberbaustein ist so konzipiert, dass er mit der gleichen, unipolaren Betriebsspannung wie die Recheneinheit versorgt wird. Dazu weist die elektrische Schaltungsanordnung eine gemeinsame Spannungsversorgungseinrichtung auf, die lediglich eine für den Treiberbaustein und die Recheneinheit gleiche Betriebsspannung bereitstellen muss, wodurch aufgabengemäß der schaltungstechnische Aufwand verringert wird. Insbesondere wird kein Schaltregler benötigt, was sich wiederum positiv im Hinblick auf die elektromagnetische Verträglichkeit (EMV) auswirkt.

Bevorzugt ist der Treiberbaustein dazu ausgelegt, die Stromrichtung in der Sekundärwicklung durch einen Wechsel der Polarität an der Sekundärwicklung umzukehren.

Durch den Polaritätswechsel an der Sekundärwicklung ist nur eine unipolare Spannungsversorgung erforderlich. Die Stromrichtung in der Sekundärwicklung wird infolge des Polaritätswechsels invertiert und der magnetische Fluss in dem Ringkern aus dem momentanen Sättigungsbereich heraus zurück bis in die jeweils entgegengesetzte Sättigung getrieben.

Mit Vorteil ist die Datenschnittstelle zur Ausgabe des Differenzstrom-Messwertes in digitaler Form und/oder mittels eines D/A-Umsetzers in analoger Form ausgelegt.

Der Differenzstrom-Messwert wird am Ausgang der Recheneinheit über die Datenschnittstelle als digitales Signal oder in Verbindung mit einem in der Recheneinheit integrierten D/A-Umsetzer als analoges Signal für eine weitere Verarbeitung oder eine optische/akustische Darstellung bereitgestellt.

In weiterer Ausgestaltung weist der Messstromwandler eine Prüf- und Kalibrierwicklung auf.

Die Prüf- und Kalibrierwicklung ermöglicht eine Funktionsprüfung sowie eine Kalibrierung der elektrischen Schaltungsanordnung.

Vorzugsweise weist die Prüf- und Kalibrierwicklung eine gleiche Windungsanzahl wie die Sekundärwicklung auf.

In dieser Ausgestaltung sind die Messwicklung (Sekundärwicklung) und die Prüf- und Kalibrierwicklung gleichartig mit wenigen Windungen ausgeführt, sodass sie in dem gleichen Arbeitsschritt hergestellt werden können, was zu einer fertigungstechnischen Vereinfachung führt.

Die der Erfindung zugrundeliegende Aufgabe wird weiterhin gelöst durch ein Messverfahren zur galvanisch getrennten, allstromsensitiven Differenzstrommessung.

Das beanspruchte Messverfahren beschreibt die von der erfindungsgemä-ßen elektrischen Schaltungsanordnung umgesetzten Verfahrensschritte, um den Differenzstrom allstromsensitiv zu bestimmen. Insoweit treffen auch die vorgenannten für die elektrische Schaltungsanordnung zutreffenden technischen Wirkungen und daraus resultierenden Vorteile auf die Verfahrensmerkmale zu.

Die Zusammenführung der Treiberschaltung mit der Oszillatorschaltung als integraler Treiberbaustein einerseits, verbunden mit der Auswertung der Verweilzeiten mittels einer Mikroprozessor-orientierten Recheneinheit andererseits, stellen eine schaltungstechnisch und wirtschaftlich effiziente Implementierung dar, die nur eine unipolare Spannungsquelle erfordert und zugleich eine Anpassung der Messparameter an die Messaufgabe mit flexibler Auswertung der Messwerte erlaubt.

Weitere vorteilhafte Ausgestaltungsmerkmale ergeben sich aus der nachfolgenden Beschreibung und den Zeichnungen, die eine bevorzugte Ausführungsform der Erfindung beispielhaft erläutern.

Es zeigen:
- **Fig. 1**: ein Durchfahren einer Magnetisierungskurve eines Messstromwandlers in schematischer Darstellung,
- **Fig. 2**: ein funktionales Blockschaltbild der erfindungsgemäßen elektrischen Schaltungsanordnung und
- **Fig. 3**: einen dem Messverfahren zugrundeliegenden Signalfluss.

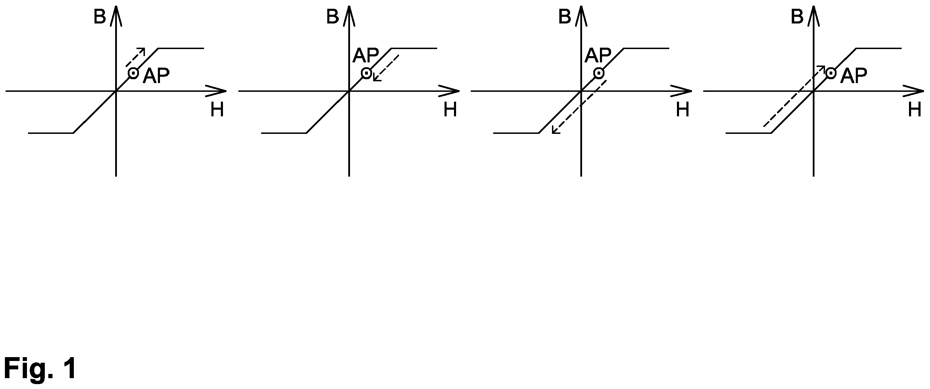

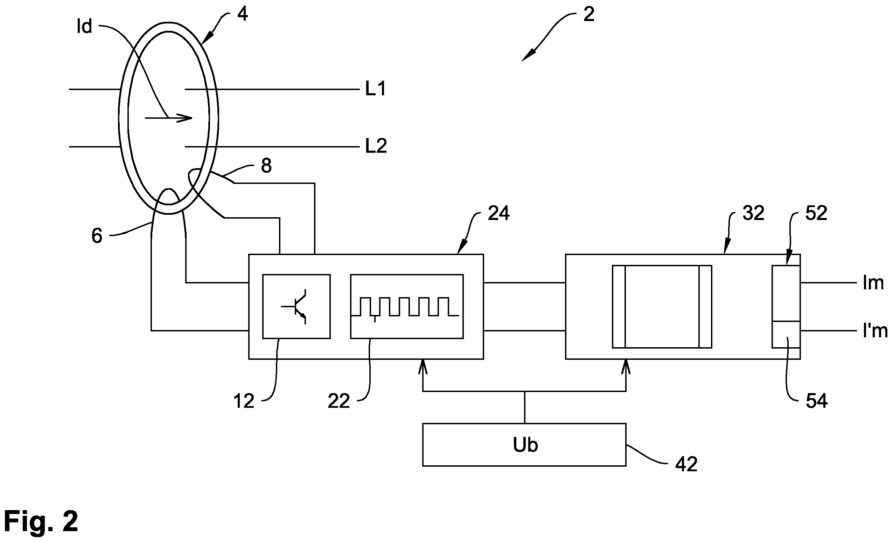

In **Fig. 1** ist ein Durchfahren einer Magnetisierungskurve des Messstromwandlers (Ringkern-Stromwandlers) 4 (Fig. 2) schematisch dargestellt.

Die Magnetisierungskurve stellt die magnetischen Induktion B in Abhängigkeit der magnetischen Feldstärke H dar und besteht aus einem linearen Abschnitt, der zwischen einem oberen und einem unteren Sättigungsbereich verläuft.

Ausgehend von dem durch den Differenzstrom I_{d} (Fig. 2) vorgegebenen Arbeitspunkt AP wird die Magnetisierungskurve zunächst durch einen zunehmenden Strom in der Sekundärwicklung 6 (Fig. 2) in Richtung des positiven Sättigungszustands durchlaufen. In dem Arbeitspunkt AP beträgt der Wert des in der Sekundärwicklung 6 fließenden Stroms (Sekundärstrom) null, sodass der Arbeitspunkt AP nur durch den primärseitig fließenden Differenzstrom I_{d} bestimmt wird. Das Erreichen des Sättigungsbereiches wird durch eine Betragsmessung des Sekundärstroms und den Vergleich mit einem hinreichend hoch gewählten Sättigungs-Grenzwert, welcher im Sättigungsbereich des Kernmaterials liegt, erkannt. Überschreitet der Sekundärstrom diesen Sättigungs-Grenzwert, kippt die Oszillatorschaltung. Die Polarität der Sekundärwicklung wird dann invertiert und der magnetische Fluss B im Kern aus dem Sättigungsbereich heraus zurück bis in die jeweils entgegengesetzte Sättigung getrieben.

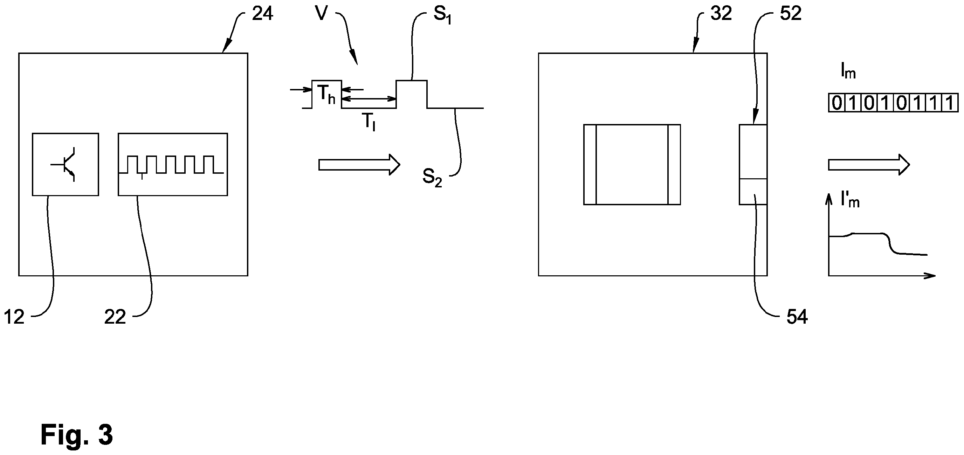

Aus dem Durchlaufen der Magnetisierungskurve wird ersichtlich, dass die jeweilige Dauer eines zunehmenden und abnehmenden Sekundärstroms, also die Verweilzeiten Tₕ, T₁, (Fig. 3) abhängig sind von der Lage des Arbeitspunktes AP auf der Magnetisierungskurve. Aus der Kenntnis des Nulldurchgangs und der Kipppunkte des Sekundärstroms kann somit ein zeitmoduliertes, binäres Messsignal V (Oszillatorsignal) (Fig. 3) mit Verweilzeiten Tₕ, T₁ in einem ersten Zustand S₁ und einem zweiten Zustand S₂ (Fig. 3) abgeleitet werden.

**Fig. 2** zeigt ein funktionales Blockschaltbild der erfindungsgemäßen elektrischen Schaltungsanordnung 2.

Der zu messende (Gleich- oder Wechsel-)Differenzstrom I_{d} (Primärstrom) wird von dem Ringkern-Stromwandler 4 erfasst, wodurch sich ein bestimmter Arbeitspunkt AP auf der Magnetisierungskurve (Fig. 1) einstellt. Der Differenzstrom I_{d} kann sich beispielsweise aufgrund eines Fehlerstroms in einem Gleichspannungs-Stromversorgungssystem oder in einem ein- oder mehrphasigen Wechselspannungs-Stromversorgungssystem ergeben, wobei das Stromversorgungssystem ein geerdetes oder ein ungeerdetes Stromversorgungssystem sein kann. Beispielhaft dargestellt sind zwei aktive Leiter L1, L2 eines Stromversorgungsystems, die als Primärwicklung wirkend von dem Ringkern des Messstromwandlers 4 umschlossen werden.

Zum Durchfahren der Magnetisierungskurve in beiden Richtungen weist der Ringkern-Stromwandler 4 eine Sekundärwicklung 6 auf, die von einer Treiberschaltung 12 bestromt wird.

Dazu liegen über einen (nicht dargestellten) strombegrenzenden Vorwiderstand jeweils an den Wicklungsenden der Sekundärwicklung 6 entweder die Spannung [0V und Ub] (Fig. 2) im Zustand S1 (Fig. 3) oder mit umgekehrter Polarität die Spannung [Ub und 0V] im Zustand S2 (Fig. 3) an. Dies ermöglicht es, durch ein einfaches Umschalten der Polarität (Polaritätswechsel) beide Stromrichtungen abzudecken, ohne eine zusätzliche Spannungsquelle, beispielsweise mit negativer Spannung, zu benötigen. Die Betriebsspannung Ub (Fig. 2) beträgt vorzugsweise 3.3V, kann aber beispielsweise auch 3V oder 5V betragen oder einen Wert in dieser Größenordnung annehmen.

Die mit dem Stromfluss in der Sekundärwicklung 6 verknüpfte magnetische Feldstärke H erzeugt in dem Kernmaterial die magnetische Induktion B.

Im Gegensatz zu aus dem Stand der Technik bekannten DC-Stromsensoren zur Hochstrommessung, die zur Erreichung eines hinreichend großen Sättigungs-Induktionsflusses mit einer Sekundär-Windungsanzahl von N=1000 und einer entsprechend großen Induktivität ausgeführt sind, weist die in der vorliegenden Erfindung verwendete Sekundärspule 6 eine Windungsanzahl in der Größenordnung von N=10 bis 100 und eine daraus resultierende geringe Induktivität auf. Dies erlaubt eine digitale Signalverarbeitung des Sekundärstroms mit einer hohen Abtastrate in der Größenordnung von einigen Tausend und eignet sich damit aufgabengemäß zur Messung geringer Differenzströme im Bereich bis zu 300 mA.

Der Ringkern des Messstromwandlers 4 ist mit einer Prüf- und Kalibrierwicklung 8 versehen, die vorzugsweise mit der gleichen Windungsanzahl wie die Sekundärwicklung 6 ausgeführt ist und der Funktionsprüfung und Kalibrierung der elektrischen Schaltungsanordnung 2 dient.

Die Treiberschaltung 12 wird von einer Oszillatorschaltung 22 gesteuert, wobei unter Auswertung der Nulldurchgänge und der Kipppunkte des Sekundärstroms in der Sekundärwicklung 6 ein Oszillatorsignal V (Fig. 3) gewonnen wird.

Das Durchfahren der Magnetisierungskurve wird somit in die Verweilzeiten Tₕ, T₁ (Fig. 3) mit einem ersten Zustand S₁ (High-Phase) und mit einem zweiten Zustand S₂ (Low-Phase) abgebildet, wobei sich die den durchfahrenen Strecken auf der Magnetisierungskurve entsprechenden Verweilzeiten Tₕ, T₁ in Abhängigkeit des durch den Differenzstrom I_{d} vorgegebenen Arbeitspunktes AP ergeben.

Befindet sich beispielsweise der Arbeitspunkt AP in Folge eines relativ hohen Differenzstroms I_{d} nahe dem oberen Sättigungspunkt auf dem linearen Streckenabschnitt der Magnetisierungskurve, so wird bei dem Durchfahren der Magnetisierungskurve ausgehend von dem Arbeitspunkt AP eine kürzere Strecke auf dem linearen Abschnitt durchlaufen als bei einem kleineren Differenzstrom - es ergibt sich eine kürzere Verweilzeit. Wie oben dargelegt, weist das auf diese Weise zeitmodulierte, binäre Messsignal V daher je nach Lage des Arbeitspunktes AP und damit in Abhängigkeit des Differenzstroms I_{d} unterschiedlich lange Verweilzeiten Tₕ, T₁ in den Zuständen S₁ und S₂ auf.

Erfindungsgemäß bilden die Treiberschaltung 12 und die Oszillatorschaltung 22 eine integrale bauliche Einheit in Form eines Treiberbausteins 24. Der Treiberbaustein 24 wird von einer Spannungsversorgungseinrichtung 42 mit der gleichen gemeinsamen, unipolaren Betriebsspannung Ub versorgt wie eine Recheneinheit 32.

Die Auswertung der Verweilzeiten Tₕ, T₁ besteht in der Bestimmung der Dauer der jeweiligen Verweilzeit Tₕ, T₁ und erfolgt durch ein in der Recheneinheit 32 generiertes Taktsignal.

Die Recheneinheit 32 ist als Mikroprozessor ausgeführt, dessen Programmierung eine flexible und schnelle Anpassung an die jeweilige, beispielsweise durch den Messbereich und die Messumgebung bestimmte, Messaufgabe erlaubt.

Ausgangsseitig stellt die Recheneinheit 32 über eine Datenschnittstelle 52 einen dem Differenzstrom I_{d} proportionalen Differenzstrom-Messwert Iₘ bereit. Dieser Differenzstrom-Messwert Iₘ kann über die Datenschnittstelle 52 direkt in digitalem Format Iₘ und/oder mittels eines D/A-Umsetzers 54 als analoger Differenzstrom-Messwert I'ₘ ausgegeben werden.

**Fig. 3** zeigt einen dem Messverfahren zugrundeliegenden Signalfluss.

Das in dem Treiberbaustein 24 erzeugte zeitmodulierte, binäre Messsignal V wird an die Recheneinheit 32 weitergeleitet und dort unter Einstellung programmierbarer Messparameter, wie beispielsweise die Messauflösung oder der Messbereich, softwaretechnisch ausgewertet.

Der so aus den Verweilzeiten Tₕ, Tₗ berechnete Differenzstrom-Messwert Iₘ wird über die Datenschnittstelle 52 unmittelbar als digitaler Differenzstrom-Messwert Iₘ und/oder über den D/A-Umsetzer 54 als analoger Differenzstrom-Messwert I'ₘ zur weiteren Verarbeitung oder Darstellung bereitgestellt.

## Patentansprüche

1. Elektrische Schaltungsanordnung (2) zur galvanisch getrennten, allstromsensitiven Differenzstrommessung, bestehend aus einem Messstromwandler (4) mit einem Ringkern und genau einer Sekundärwicklung (6) zur Erfassung eines Differenzstroms (I_{d}), einer Treiberschaltung (12) mit einer Oszillatorschaltung (22) zur Bestromung der Sekundärwicklung (6) und zur Erzeugung eines zeitmodulierten, binären Messsignals (V) mit einer jeweiligen Verweilzeit (Tₕ, Tₗ) in einem ersten Zustand (S₁) und einem zweiten Zustand (S₂),
einer Recheneinheit (32) mit einer Datenschnittstelle (52) zur Auswertung der Verweilzeiten (Tₕ, T₁) und zur Ausgabe eines Differenzstrom-Messwertes (Im, I'ₘ),
**dadurch gekennzeichnet,**
**dass** die Treiberschaltung (12) mit der Oszillatorschaltung (22) eine integrale bauliche Einheit in Form eines Treiberbausteins (24) bildet, welcher ausgelegt ist, von einer Spannungsversorgungseinrichtung (42) zusammen mit der Recheneinheit (32) mit einer gemeinsamen, unipolaren Betriebsspannung (Ub) versorgt zu werden.

2. Elektrische Schaltungsanordnung (2) nach Anspruch 1,
**dadurch gekennzeichnet,**
**dass** der Treiberbaustein (24) dazu ausgelegt ist, die Stromrichtung in der Sekundärwicklung (6) durch einen Wechsel der Polarität an der Sekundärwicklung (6) umzukehren.

3. Elektrische Schaltungsanordnung (2) nach Anspruch 1 oder 2,
**dadurch gekennzeichnet,**
**dass** die Datenschnittstelle (52) ausgelegt ist zur Ausgabe des Differenzstrom-Messwertes (Iₘ, I'ₘ) in digitaler Form (Iₘ) und/oder mittels eines D/A-Umsetzers (54) in analoger Form (I'ₘ).

4. Elektrische Schaltungsanordnung (2) nach einem der Ansprüche 1 bis 3,
**dadurch gekennzeichnet,**
**dass** der Messstromwandler (4) eine Prüf- und Kalibrierwicklung (8) aufweist.

5. Elektrische Schaltungsanordnung (2) nach Anspruch 4,
**dadurch gekennzeichnet,**
**dass** die Prüf- und Kalibrierwicklung (8) eine gleiche Windungsanzahl wie die Sekundärwicklung (6) aufweist.

6. Messverfahren zur galvanisch getrennten, allstromsensitiven Differenzstrommessung, umfassend die Verfahrensschritte:
Erfassen eines Differenzstroms (I_{d}) mittels eines Messstromwandlers (4) mit einem Ringkern und genau einer Sekundärwicklung (6), Bestromen der Sekundärwicklung (6) und Erzeugen eines zeitmodulierten, binären Messsignals (V) mit einer jeweiligen Verweilzeit (Tₕ, T₁) in einem ersten Zustand (S₁) und einem zweiten Zustand (S₂) mittels einer Treiberschaltung (12) mit einer Oszillatorschaltung (22) ,
Auswerten der Verweilzeiten (Tₕ, Tₗ) mittels einer Recheneinheit (32) und Ausgeben eines Differenzstrom-Messwertes (Iₘ, I'ₘ) mittels einer Datenschnittstelle (52),
**dadurch gekennzeichnet,**
**dass** die Treiberschaltung (12) mit der Oszillatorschaltung (22) eine integrale bauliche Einheit in Form eines Treiberbausteins (24) bildet,
welcher von einer Spannungsversorgungseinrichtung (42) zusammen mit der Recheneinheit (32) mit einer gemeinsamen, unipolaren Betriebsspannung (Ub) versorgt wird.

7. Messverfahren nach Anspruch 6,
**dadurch gekennzeichnet,**
**dass** die Stromrichtung in der Sekundärwicklung (6) durch einen Wechsel der Polarität an der Sekundärwicklung (6) mittels des Treiberbausteins (24) umgekehrt wird.

8. Messverfahren nach Anspruch 6 oder 7,
**dadurch gekennzeichnet,**
**dass** die Ausgabe des Differenzstrom-Messwertes (Iₘ, I'ₘ) über die Datenschnittstelle (52) in digitaler Form (Iₘ) und/oder mittels eines D/A-Umsetzers (54) in analoger Form (I'ₘ) erfolgt.

9. Messverfahren nach einem der Ansprüche 6 bis 8,
**dadurch gekennzeichnet,**
**dass** ein Prüfen und Kalibrieren des Messstromwandlers (4) mittels einer Prüf- und Kalibrierwicklung (8) erfolgt.
